# EUROPÄISCHE PATENTSCHRIFT

(11) **EP 2 220 733 B1**
(45) Veröffentlichungstag und Bekanntmachung des Hinweises auf die Patenterteilung: **10.10.2018**
(21) Anmeldenummer: 08863511.5
(22) Anmeldetag: 16.12.2008
(51) Int. Cl.: H01S 5/10, H01S 5/22, H01S 5/40

(54) **LASERLICHTQUELLE**
LASER LIGHT SOURCE
SOURCE DE LUMIÈRE LASER

(30) Priorität: 21.12.2007 DE 102007061922; 12.03.2008 DE 102008013896
(43) Veröffentlichungstag der Anmeldung: 25.08.2010
(73) Patentinhaber: OSRAM Opto Semiconductors GmbH, 93055 Regensburg (DE)
(72) Erfinder: REILL, Wolfgang, 93080 Pentling (DE); TAUTZ, Sönke, 93105 Tegernheim (DE); BRICK, Peter, 93051 Regensburg (DE); STRAUSS, Uwe, 93077 Bad Abbach (DE)
(74) Vertreter: Epping - Hermann - Fischer
(86) Internationale Anmeldenummer: PCT/DE2008/002123
(87) Internationale Veröffentlichungsnummer: WO 2009/080011

(56) Entgegenhaltungen:
- FR-A- 2 879 840
- US-A- 5 555 544

## Beschreibung

Diese Patentanmeldung beansprucht die Prioritäten der deutschen Patentanmeldung 10 2007 061 922.9 und der deutschen Patentanmeldung 10 2008 013 896.7.

Im Folgenden wird eine Laserlichtquelle mit eine Halbleiterschichtenfolge angegeben.

Lasersysteme für optische Anwendungen, etwa Projektionsanwendungen, sowie für Laserpumpquellen zur Einkopplung in optische Fasern benötigen eine hohe Brillanz, das heißt eine hohe Leistung und eine hohe Strahlqualität. Letztere ist gegeben durch das so genannte Strahlparameterprodukt, das heißt das Produkt aus dem Strahltaillenradius und dem Divergenzwinkel des vom Laser abgestrahlten Lichts. Weiterhin kann es etwa für Materialbearbeitungsanwendungen und für Pumplaser für Festkörperlaser wünschenswert sein, Laser mit hoher Leistung bei kleiner Abstrahlfläche einzusetzen.

Die Druckschrift FR 2879840 offenbart einen Halbleiterlaser mit einer Schichtenfolge mit einem aktiven Bereich, der einen streifenförmigen Teil und einen trapezförmigen Verstärkungsteil aufweist sowie neben dem streifenförmigen Teil Reflektoren.

In der Druckschrift US 5,555,544 sind Halbleiterlaser-Oszillatorstrukturen mit jeweils einer Tapered-Ridge-Struktur mit Spoilern beschrieben, die als Laserverstärker oder als Laseroszillatoren verwendet werden können.

Eine Aufgabe zumindest einer Ausführungsform ist es, eine Laserlichtquelle mit einer Halbleiterschichtenfolge mit zumindest zwei aktiven Bereichen anzugeben.

Diese Aufgabe wird durch einen Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen aus der nachfolgenden Beschreibung und den Zeichnungen hervor.

Gemäß zumindest einer Ausführungsform umfasst eine Laserlichtquelle insbesondere
- eine Halbleiterschichtenfolge mit einer aktiven Schicht mit zumindest zwei aktiven Bereichen, die geeignet sind, im Betrieb elektromagnetische Strahlung über eine als Strahlungsauskoppelfläche ausgeführte Seitenfläche der Halbleiterschichtenfolge entlang einer Abstrahlrichtung abzustrahlen,
- jeweils eine elektrische Kontaktfläche über jedem der zumindest zwei aktiven Bereiche auf einer Hauptoberfläche der Halbleiterschichtenfolge und
- eine Oberflächenstruktur in der Hauptoberfläche der Halbleiterschichtenfolge,
   wobei
- die zumindest zwei aktiven Bereiche quer zur Abstrahlrichtung zueinander beabstandet in der aktiven Schicht angeordnet sind,
- jede der elektrischen Kontaktflächen einen ersten Teilbereich aufweist und einen zweiten Teilbereich mit einer sich entlang der Abstrahlrichtung zur Strahlungsauskoppelfläche hin vergrößernden Breite,
- die Oberflächenstruktur zwischen den zumindest zwei elektrischen Kontaktflächen zumindest eine erste Vertiefung entlang der Abstrahlrichtung sowie zweite Vertiefungen aufweist und
- die ersten Teilbereiche der elektrischen Kontaktflächen jeweils zwischen zumindest zwei zweiten Vertiefungen angeordnet sind.

Hier und im Folgenden kann "quer" bedeuten, dass eine erste Richtung, die quer zu einer zweiten Richtung ausgebildet ist, zumindest eine Richtungskomponente aufweist, die senkrecht zur zweiten Richtung ist. Insbesondere kann das bedeuten, dass die erste Richtung senkrecht zur zweiten Richtung ist.

Hier und im Folgenden kann "Licht" oder "elektromagnetische Strahlung" gleichermaßen insbesondere elektromagnetische Strahlung mit zumindest einer Wellenlänge oder einem Wellenlängenbereich aus einem infraroten bis ultravioletten Wellenlängenbereich bedeuten. Insbesondere kann das Licht oder die elektromagnetische Strahlung einen sichtbaren, also einen roten bis blauen Wellenlängenbereich mit einer oder mehreren Wellenlängen zwischen etwa 450 nm und etwa 700 nm umfassen. Dabei kann die Halbleiterschichtenfolge im Betrieb insbesondere durch stimulierte Emission hervorgerufene kohärente elektromagnetische Strahlung erzeugen, die etwa durch ein Spektrum im einem Wellenlängenbereich mit einer spektralen Breite von weniger als 10 nm und bevorzugt weniger als 5 nm charakterisiert sein kann. Weiterhin kann die kohärente elektromagnetische Strahlung eine Kohärenzlänge in einer Größenordnung von Metern bis zu einer Größenordnung von hundert Metern oder mehr aufweisen. Jeder aktive Bereich kann dabei ein eigenes Strahlenbündel kohärenter elektromagnetischer Strahlung abstrahlen. Die Strahlenbündel können jeweils Strahleigenschaften ähnlich oder gleich einem idealen Gaußschen Strahlenbündel aufweisen.

Die Halbleiterschichtenfolge mit zumindest zwei aktiven Bereichen kann geeignet sein, die Leistung beziehungsweise die Intensität der von der Laserlichtquelle abgestrahlten elektromagnetischen Strahlung im Vergleich zu einer Laserlichtquelle mit nur einem aktiven Bereich zu erhöhen. Insbesondere kann die Laserlichtquelle als so genanter Laserbarren mit einer Mehrzahl von aktiven Bereichen ausgeführt sein.

Die von den aktiven Bereichen jeweils abgestrahlten Strahlenbündel kohärenter elektromagnetischer Strahlung können weiterhin in einem Strahlenbündel kollimierbar und/oder fokussierbar sein kann. Dazu kann der Strahlungsauskoppelfläche der Halbleiterschichtenfolge und insbesondere den aktiven Bereichen eine Kollimations- oder Fokussierungsoptik wie etwa eine oder mehrere anamorphotische Linsen, etwa eine oder mehrere Zylinderlinsen, nachgeordnet sein, mit der die elektromagnetische Strahlung zu einem Strahlenbündel kollimiert und/oder fokussiert werden kann.

Um kohärente elektromagnetische Strahlung durch stimulierte Emission zu erzeugen, können die Strahlungsauskoppelfläche und/oder die der Strahlungsauskoppelfläche gegenüberliegende Seitenfläche der Halbleiterschichtenfolge, die auch als Rückseite bezeichnet werden kann, zumindest teilweise reflektierend ausgeführt sein. Dadurch können die Strahlungsauskoppelfläche und die Rückseite einen optischen Resonator für die in den aktiven Bereichen erzeugte elektromagnetische Strahlung bilden. Dabei kann es möglich sein, dass sich in jedem der zumindest zwei aktiven Bereiche eine oder mehrere stehende elektromagnetische Wellen ausbilden, die einer oder mehreren der in den aktiven Bereichen durch den optischen Resonator vorgegebenen Moden entsprechen. Insbesondere können sich die in den zumindest zwei aktiven Bereichen ausbildenden Moden etwa in ihrer relativen Phasenlage zueinander unterscheiden.

Die Strahlungsauskoppelfläche und die Rückseite der Halbleiterschichtenfolge können beispielsweise durch Spaltung der Halbleiterschichtenfolge entlang einer Kristallebene herstellbar sein. Weiterhin können die Strahlungsauskoppelfläche und/oder die Rückseite der Halbleiterschichtenfolge eine reflektierende Beschichtung, etwa in Form von Bragg-Spiegeln, aufweisen.

Da die aktiven Bereiche in derselben aktiven Schicht angeordnet sind, kann es in bekannten Laserbarren mit mehreren aktiven Bereichen möglich sein, dass ein so genanntes optisches Übersprechen zwischen den aktiven Bereichen stattfinden kann. Dieses optische Übersprechen kann prinzipiell durch die von einem aktiven Bereich erzeugte kohärente elektromagnetische Strahlung, die in denselben aktiven Bereich zurückgestreut oder in einen anderen aktiven Bereich gestreut oder gelenkt werden kann, hervorgerufen werden. Weiterhin kann es auch möglich sein, dass neben der stimulierten Emission, die bevorzugt in den aktiven Bereichen zur Erzeugung der kohärenten elektromagnetischen Strahlung führen kann, durch zusätzlich stattfindende spontane Emission inkohärente elektromagnetische Strahlung erzeugt und isotrop abgestrahlt werden kann. Daher kann derartig erzeugte inkohärente elektromagnetische Strahlung aus einem aktiven Bereich in einen anderen aktiven Bereich gestrahlt werden. Im Folgenden wird derartige elektromagnetische Strahlung, die sich innerhalb der Halbleiterschichtenfolge ausbreitet und in einen aktiven Bereich eingestrahlt werden kann, als Streustrahlung bezeichnet. Die Streustrahlung kann die Ausbildung von stehenden Wellen, also von elektromagnetischen Feldmoden, in den aktiven Bereichen stören, was eine Verringerung der jeweils von den aktiven Bereichen abgestrahlten Leistung beziehungsweise Intensität sowie eine Verringerung der Strahlqualität zufolge haben kann.

Dadurch, dass die hier beschriebene Laserlichtquelle eine Oberflächenstruktur umfasst, die zumindest eine erste Vertiefung und zweite Vertiefungen aufweist, wird die Streustrahlung an der Ausbreitung in der Halbleiterschichtenfolge gehindert. Weiterhin kann dadurch das optische Übersprechen verringert oder verhindert werden. Die Strahlqualität der von den aktiven Bereichen der Laserlichtquelle abgestrahlten elektromagnetischen Strahlung, beispielsweise messbar in Form der dem Fachmann bekannten Beugungsmaßzahl M², kann somit im Vergleich zu herkömmlichen Laserbarren wesentlich verbessert werden.

Die Halbleiterschichtenfolge kann als Epitaxieschichtenfolge oder als strahlungsemittierender Halbleiterchip mit einer Epitaxieschichtenfolge, also als epitaktisch gewachsene Halbleiterschichtenfolge, ausgeführt sein. Dabei kann die Halbleiterschichtenfolge beispielsweise auf der Basis von AlGaAs ausgeführt sein. Unter AlGaAs-basierten Halbleiterchips und Halbleiterschichtenfolgen fallen insbesondere solche, bei denen die epitaktisch hergestellte Halbleiterschichtenfolge in der Regel eine Schichtenfolge aus unterschiedlichen Einzelschichten aufweist, die mindestens eine Einzelschicht enthält, die ein Material aus dem III-V-Verbindungshalbleitermaterialsystem AlₓGa₁₋ₓAs mit 0 ≤ x ≤ 1 aufweist. Insbesondere kann eine aktive Schicht, die ein auf AlGaAs basierendes Material aufweist, geeignet sein, elektromagnetische Strahlung mit einer oder mehreren spektralen Komponenten in einem roten bis infraroten Wellenlängenbereich zu emittieren. Weiterhin kann ein derartiges Material zusätzlich oder alternativ zu den genannten Elementen In und/oder P aufweisen.

Weiterhin kann die Halbleiterschichtenfolge beispielsweise auf der Basis von InGaAlN ausgeführt sein. Unter InGaAlNbasierten Halbleiterchips und Halbleiterschichtenfolgen fallen insbesondere solche, bei denen die epitaktisch hergestellte Halbleiterschichtenfolge in der Regel eine Schichtenfolge aus unterschiedlichen Einzelschichten aufweist, die mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x + y ≤ 1 aufweist. Halbleiterschichtenfolgen, die zumindest eine aktive Schicht auf Basis auf InGaAlN aufweisen, können beispielsweise bevorzugt elektromagnetische Strahlung in einem ultravioletten bis grünen Wellenlängenbereich emittieren.

Alternativ oder zusätzlich kann die Halbleiterschichtenfolge oder der Halbleiterchip auch auf InGaAlP basieren, das heißt, dass die Halbleiterschichtenfolge unterschiedliche Einzelschichten aufweisen kann, wovon mindestens eine Einzelschicht ein Material aus dem III-V-Verbindungshalbleitermaterialsystem InₓAl_{yG}a_{1-x-y}P mit 0 ≤ x ≤ 1, 0 ≤ y ≤ 1 und x + y ≤ 1 aufweist. Halbleiterschichtenfolgen oder Halbleiterchips, die zumindest eine aktive Schicht auf Basis von InGaAlP aufweisen, können beispielsweise bevorzugt elektromagnetische Strahlung mit einer oder mehreren spektralen Komponenten in einen grünen bis roten Wellenlängenbereich emittieren.

Alternativ oder zusätzlich kann die Halbleiterschichtenfolge oder der Halbleiterchip neben oder anstelle der III-V-Verbindungshalbleitermaterialsysteme auch II-VI-Verbindungshalbleitermaterialsysteme aufweisen.

Die Halbleiterschichtenfolge kann weiterhin ein Substrat aufweisen, auf dem die oben genannten III-V- oder II-VI-Verbindungshalbleitermaterialsystem abgeschieden sind. Das Substrat kann dabei ein Halbleitermaterial, beispielsweise ein oben genanntes Verbindungshalbleitermaterialsystem, umfassen. Insbesondere kann das Substrat GaP, GaN, SiC, Si und/oder Ge umfassen oder aus einem solchen Material sein.

Die Halbleiterschichtenfolge kann als aktive Bereiche in der aktiven Schicht beispielsweise herkömmliche pn-Übergänge, Doppelheterostrukturen, Einfach-Quantentopfstrukturen (SQW-Strukturen) oder Mehrfach-Quantentopfstrukturen (MQW-Strukturen) aufweisen. Die Halbleiterschichtenfolge kann neben der aktiven Schicht mit den aktiven Bereichen weitere funktionale Schichten und funktionelle Bereiche umfassen, etwa p- oder n-dotierte Ladungsträgertransportschichten, also Elektronen- oder Löchertransportschichten, p- oder n-dotierte Confinement-, Mantel- oder Wellenleiterschichten, Barriereschichten, Planarisierungsschichten, Pufferschichten, Schutzschichten und/oder Elektroden sowie Kombinationen daraus. Die Elektroden können dabei jeweils eine oder mehrere Metallschichten mit Ag, Au, Sn, Ti, Pt, Pd und/oder Ni aufweisen. Solche Strukturen die aktive Schicht oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

Darüber hinaus können zusätzliche Schichten, etwa Pufferschichten, Barriereschichten und/oder Schutzschichten auch senkrecht zur Aufwachsrichtung der Halbleiterschichtenfolge beispielsweise um die Halbleiterschichtenfolge herum angeordnet sein, also etwa auf den Seitenflächen der Halbleiterschichtenfolge.

Weiterhin kann die Halbleiterschichtenfolge als so genannter "Distributed Feedback Laser", kurz DFB-Laser, ausgeführt sein. Derartige DFB-Laser weisen in Abstrahlrichtung periodisch strukturierte aktive Bereiche auf. Ein periodisch strukturierter aktiver Bereich weist periodisch angeordnete Bereiche mit wechselnden Brechungsindices auf, die ein Interferenzgitter bzw. Interferenzfilter bilden können, das zu einer wellenlängenselektiven Reflexion führen kann.

Durch die Ausbildung einer Seitenfläche der Halbleiterschichtenfolge als Strahlungsauskoppelfläche kann es sich bei der Halbleiterschichtenfolge bevorzugt um eine kantenemittierende Laserdiode handeln. Bevorzugt kann die Halbleiterschichtenfolge dabei eine erste und eine zweite Wellenleiterschicht aufweisen, zwischen denen die aktive Schicht mit den aktiven Bereichen angeordnet ist und die eine Führung der in den aktiven Bereichen erzeugten elektromagnetischen Strahlung in der aktiven Schicht ermöglichen.

Die Hauptoberfläche mit den elektrischen Kontaktflächen und der Oberflächenstruktur kann eine Haupterstreckungsebene aufweisen, die senkrecht zur Aufwachsrichtung der Halbleiterschichtenfolge sein kann. Insbesondere kann die Hauptoberfläche mit den elektrischen Kontaktflächen und der Oberflächenstruktur eine einem Substrat gegenüberliegende Oberfläche der Halbleiterschichtenfolge sein.

Die elektrischen Kontaktflächen auf der Hauptoberfläche können insbesondere als solche Flächenbereiche der Hauptoberfläche ausgeführt sein, die elektrisch leitend mit einer Elektrode verbunden sind, die auf der Hauptoberfläche aufgebracht ist. Dazu kann beispielsweise eine Elektrodenschicht, die etwa eines der oben genannten Metalle umfassen kann, in Form der elektrischen Kontaktflächen auf der Hauptoberfläche strukturiert aufgebracht sein. Alternativ oder zusätzlich kann auf der Hauptoberfläche eine elektrisch isolierende Schicht derart strukturiert aufgebracht sein, dass die elektrischen Kontaktflächen frei von der elektrisch isolierenden Schicht sind und eine Elektrodenschicht strukturiert oder großflächig über der elektrisch isolierenden Schicht und den elektrischen Kontaktflächen auf der Hauptoberfläche aufgebracht ist. Alternativ oder zusätzlich kann die Halbleiterschichtenfolge strukturiert in den Bereichen der elektrischen Kontaktflächen eine Schicht mit einem hochdotierten Halbleitermaterial aufweisen, das einen ohmschen elektrischen Kontakt mit einem im Vergleich zur übrigen Hauptoberfläche niedrigen Kontaktwiderstand zu einer Elektrode ermöglicht.

Durch die Form der elektrischen Kontaktflächen und die elektrischen Leitfähigkeiten der funktionalen Schichten in Aufwachsrichtung sowie in der Erstreckungsebene der Halbleiterschichtenfolge können sich unterhalb der elektrischen Kontaktflächen in der aktiven Schicht die aktiven Bereiche ausbilden, in denen die Stromdichte hoch genug ist, um stimulierte Emission von kohärenter elektromagnetischer Strahlung zu ermöglichen. Entsprechend der ersten und zweiten Teilbereiche der elektrischen Kontaktflächen können die aktiven Bereiche ebensolche ersten und zweiten Teilbereiche aufweisen. Durch die Form der elektrischen Kontaktflächen kann somit die Modenstruktur der in den aktiven Bereichen erzeugten stehenden elektromagnetischen Wellen beeinflusst werden. Die Abstrahlrichtung der Halbleiterschichtenfolge kann der Haupterstreckungsrichtung der elektrischen Kontaktflächen und damit der Haupterstreckungsrichtung der aktiven Bereiche entsprechen.

Dabei kann es vorteilhaft sein, wenn sich der erste Teilbereich einer elektrischen Kontaktfläche entlang der Abstrahlrichtung mit einer gleich bleibenden Breite auf der Hauptoberfläche erstreckt. Insbesondere können die ersten Teilbereiche der zumindest zwei elektrischen Kontaktflächen dabei als parallel zueinander angeordnete Streifen ausgeführt sein. Die ersten Teilbereiche der elektrischen Kontaktflächen können weiterhin an die der Strahlungsauskoppelfläche gegenüberliegenden Rückseite der Halbleiterschichtenfolge angrenzen. Die Breite der ersten Teilbereiche kann dabei kleiner oder gleich 20 µm, bevorzugt kleiner oder gleich 10 µm und besonders bevorzugt kleiner oder gleich 5 um sein.

Der erste Teilbereich einer elektrischen Kontaktfläche kann weiterhin direkt an den zweiten Teilbereich angrenzen. Das kann bedeuten, dass der zweite Teilbereich in einem Grenzbereich, in dem der zweite Teilbereich an den ersten Teilbereich angrenzt, dieselbe Breite wie der erste Teilbereich aufweist. Insbesondere kann sich der zweite Teilbereich dabei vom ersten Teilbereich weg in Abstrahlrichtung linear verbreitern. Das kann insbesondere bedeuten, dass der zweite Teilbereich eine Trapezform aufweist, die weiterhin symmetrisch zur Abstrahlrichtung sein kann. Der zweite Teilbereich kann sich dabei in Abstrahlrichtung auf eine Breite größer oder gleich 50 µm, größer oder gleich 100 µm oder größer oder gleich 200 µm verbreitern. Insbesondere kann der Öffnungswinkel, unter dem sich der zweite Teilbereich verbreitert, größer oder gleich 1° und kleiner oder gleich 10° und insbesondere größer oder gleich 2° und kleiner oder gleich 6° sein, was sich aus dem Gaußschen Formalismus beugungsbegrenzter Strahlen ergibt. Die Führung der elektromagnetischen Strahlung im zweiten Teilbereich kann dabei nach dem Prinzip der Gewinnführung erfolgen, was bedeutet, dass im ersten Teilbereich ein zumindest nahezu Gaußscher Strahl erzeugt wird, für den aufgrund der geringen Breite des ersten Teilbereichs große Beugungswinkel möglich sein können. Weiterhin kann der nahezu Gaußsche Strahl aus dem ersten Teilbereich frei in den zweiten Teilbereich beugen und effektiv während der Ausbreitung entlang des zweiten Teilbereichs an Leistung gewinnen. Dabei kann der zweite Teilbereich an die Strahlungsauskoppelfläche angrenzen, über die im aktiven Bereich erzeugte und verstärkte elektromagnetische Strahlung direkt abgestrahlt werden kann.

Dabei kann es vorteilhaft sein, wenn Schichten der Halbleiterschichtenfolge derartig stegförmig strukturiert sind, dass die Hauptoberfläche mit den elektrischen Kontaktflächen die stegförmigen Strukturen umfasst. Insbesondere kann eine solche auch als "Ridge-Struktur" oder Stegwellenleiterstruktur bekannte Ausgestaltungen der Hauptoberfläche der Halbleiterschichtenfolge geeignet sein, in Abhängigkeit von ihrer Breite und Höhe und durch die aufgrund der stegförmigen Struktur und einem damit verbundenen Brechungsindexsprung von etwa 0,005 bis 0,01 hervorgerufene so genannte Indexführung die Ausbildung einer transversalen Grundmode im aktiven Bereich zu ermöglichen. Dabei kann die Höhe einer Ridge-Struktur in größerem Maße als die Breite den genannten Brechungsindexsprung beeinflussen. Breite und Höhe der Ridge-Struktur können weiterhin auch den Öffnungswinkel des nahezu Gaußschen Strahls aus dem ersten Teilbereich beim Eintreten in den zweiten Teilbereich eines aktiven Bereichs bestimmen. Insbesondere weist die Hauptoberfläche derartige stegförmige Strukturen beziehungsweise Ridge-Strukturen auf, auf denen jeweils der erste und der zweite Teilbereich der elektrischen Kontaktflächen angeordnet sind.

Die Ridge-Struktur kann dabei beispielsweise im ersten Teilbereich bis zu einer ersten Tiefe und im zweiten Teilbereich bis zu einer zweiten Tiefe strukturiert sein, wobei die erste und zweite Tiefe gleich oder verschieden sein können. Insbesondere kann beispielsweise die erste Tiefe zur Indexführung bis zu einer Wellenleiterschicht reichen, während die zweite Tiefe zur oben beschrieben Gewinnführung bis zu einer über der Wellenleiterschicht angeordneten Halbleiterkontaktschicht oder Mantelschicht reichen kann. Weiterhin kann die erste Tiefe auch bis in eine Mantelschicht reichen, während die zweite Tiefe bis zu einer Grenzfläche zwischen der Mantelschicht und einer darüber angeordneten Halbleiterkontaktschicht reichen kann oder sogar nur bis in die Halbleiterkontaktschicht.

Zur Herstellung der Ridge-Struktur kann beispielsweise eine Halbleiterschichtenfolge mit den oben genannten funktionalen Schichten bereitgestellt werden. Die Ridge-Struktur kann dann durch eine Maske mittels eines abtragenden Verfahrens, etwa Ätzen, auf der Hauptoberfläche der Halbleiterschichtenfolge erzeugt werden. Die Breite der Ridge-Struktur im ersten und zweiten Teilbereich der späteren elektrischen Kontaktfläche kann dabei über eine photolithographisch herstellbare Maske einstellbar sein. Um eine definierte und gleichmäßige Höhe der Ridge-Struktur zu erhalten, kann die Halbleiterschichtenfolge eine so genannte Ätzstoppschicht aufweisen. Beispielsweise bei einer Halbleiterschichtenfolge, die auf AlGaAs basierende Materialien aufweist, kann die Ätzstoppschicht eine Al-freie, P-haltige Schicht in einer oder zwischen zwei Schichten der Halbleiterschichtenfolge aufweisen. Die Ätzstoppschicht kann dabei beispielsweise ein Al-freies, P-haltiges GaAs-Halbleitermaterial und/oder InGaP aufweisen oder daraus sein. Beispielsweise kann die Ätzstoppschicht in einer zwischen der aktiven Schicht und der Hauptoberfläche angeordneten Wellenleiterschicht angeordnet sein. Dabei können die Dicke, Dotierung und/oder Lage der Ätzstoppschicht in der Wellenleiterschicht an die Wellenleiterschicht angepasst werden. Die Ätzstoppschicht kann dabei nach dem Ätzen an die Ridge-Struktur angrenzen und einen Teil der Hauptoberfläche bilden.

Um das oben beschriebene optische Übersprechen zwischen den aktiven Bereichen zu vermeiden, kann die erste Vertiefung derart weit von der Hauptoberfläche in die Halbleiterschichtenfolge hineinragen, dass eine Ausbreitung der Streustrahlung in der Halbleiterschichtenfolge verringert oder verhindert werden kann. Die erste Vertiefung kann dabei in eine der funktionalen Schichten der Halbleiterschichtenfolge reichen. Dass die erste Vertiefung "in eine Schicht reicht", kann bedeuten, dass die erste Vertiefung in der Schicht endet und die Schicht im Bereich der ersten Vertiefung eine geringere Dicke aufweist als neben der ersten Vertiefung. Weiterhin kann es bedeuten, dass die erste Vertiefung die Schicht gerade durchstößt und sich somit bis zu einer Grenzfläche zu einer unterhalb der Schicht angeordneten weiteren Schicht erstreckt. Beispielsweise kann die Halbleiterschichtenfolge zwei Wellenleiterschichten aufweisen, zwischen denen die aktive Schicht angeordnet ist. Die erste Vertiefung kann zumindest in die Wellenleiterschicht zwischen der aktiven Schicht und der Hauptoberfläche reichen. Weiterhin kann die erste Vertiefung bis in die aktive Schicht oder bis in die, von der Hauptoberfläche gesehen, unterhalb der aktiven Schicht angeordneten Wellenleiterschicht reichen. Darüber hinaus kann die erste Vertiefung bis in eine Schicht unterhalb der Wellenleiterschichten und der aktiven Schicht reichen, etwa eine Mantel- oder Zwischenschicht, oder bis ein Substrat, auf dem die funktionalen Schichten aufgebracht sind.

Weiterhin kann sich die erste Vertiefung auf der Hauptoberfläche von der Strahlungsauskoppelfläche bis zur der Strahlungsauskoppelfläche gegenüberliegenden Rückseite der Halbleiterschichtenfolge erstrecken. Die erste Vertiefung kann dabei beispielsweise zumindest einen Graben umfassen, der sich parallel zu den aktiven Bereichen entlang der Abstrahlrichtung erstreckt. Alternativ oder zusätzlich kann die erste Vertiefung auch eine Mehrzahl von nebeneinander und/oder hintereinander angeordneten Gräben oder Vertiefungen aufweisen.

Die erste Vertiefung kann Seitenwände aufweisen, die sich entlang der Aufwachsrichtung der Halbleiterschichtenfolge erstrecken und mit der Hauptoberfläche einen Winkel von größer oder gleich 90° einschließen können. Dabei kann ein Winkel von 90° bedeuten, dass die erste Vertiefung Seitenwände aufweist, die parallel zur Aufwachsrichtung der Halbleiterschichtenfolge und damit senkrecht zur Hauptoberfläche ausgeführt sind. Ein Winkel größer als 90° bedeutet, dass die Kante zwischen einer Seitenwand der ersten Vertiefung und der Hauptoberfläche einen stumpfen Winkel bildet. Somit verringert sich der Querschnitt der ersten Vertiefung in eine Richtung von der Hauptoberfläche aus gesehen in die Halbleiterschichtenfolge hinein. Die erste Vertiefung kann dabei einen V-förmigen oder einen U-förmigen Querschnitt oder eine Kombination daraus aufweisen. Insbesondere kann die erste Vertiefung Seitenwände aufweisen, die mit der Hauptoberfläche eine Kante mit einem Winkel von kleiner oder gleich 135° und bevorzugt gleich 135° bilden. Dadurch kann Streustrahlung, die sich in der Halbleiterschichtenfolge ausbreitet und auf die Seitenwand der ersten Vertiefung trifft, von der Hauptoberfläche aus gesehen nach unten in unterhalb der aktiven Schicht liegende funktionale Schichten und/oder ein Substrat reflektiert und in diesen absorbiert werden. Dazu kann die Halbleiterschichtenfolge beispielsweise zusätzlich eine Schicht mit einem absorbierenden Material unterhalb der aktiven Schicht aufweisen.

Weiterhin kann die erste Vertiefung zumindest teilweise mit einem absorbierenden Material gefüllt sein. Das kann bedeuten, dass zumindest die Seitenwände der ersten Vertiefung mit einem absorbierenden Material beschichtet sein können. Streustrahlung, die sich in der Halbleiterschichtenfolge ausbreitet und auf die erste Vertiefung trifft, kann somit absorbiert und an der weiteren Ausbreitung in der Halbleiterschichtenfolge gehindert werden.

Das absorbierende Material kann beispielsweise Gallium, Aluminium, Chrom oder Titan oder eine Kombination daraus aufweisen. Weiterhin kann das absorbierende Material ein Halbleitermaterial, etwa Silizium, Germanium, InAlGaAs, InGaAlP und InGaAlN, ZnSe und/oder ZnS aufweisen. Das Halbleitermaterial kann bevorzugt eine Bandlücke aufweisen, die kleiner oder gleich der Wellenlänge der in den aktiven Bereichen erzeugten elektromagnetischen Strahlung ist. Weiterhin kann das absorbierende Material Antimon oder eine Schicht oder einen Schichtenstapel mit Antimon mit einem oder mehreren der Materialien N, Te, Ge, Ag und In aufweisen, beispielsweise Antimonnitrid (SbNₓ), SbTe, GeSbTe und/oder AgInSbTe. Alternativ oder zusätzlich kann das erste Filterelement auch eine Schicht oder einen Schichtenstapel mit AgOₓ, PtOₓ und/oder PdOₓ aufweisen. Derartige Schichten oder Schichtenstapel sind auch als "super-resolution nearfield structure" (Super-RENS) bekannt, die unterhalb einer Grenztemperatur nicht transparent und absorbierend für elektromagnetische Strahlung sein können.

Durch die hier beschriebene erste Vertiefung können die zumindest zwei aktiven Bereiche damit wirksam optisch getrennt werden, so dass kein optisches Übersprechen zwischen den aktiven Bereichen mehr stattfinden kann.

Weiterhin kann zumindest eine zweite Vertiefung der zweiten Vertiefungen wie im Zusammenhang mit der ersten Vertiefung beschrieben in eine Schicht der Halbleiterschichtenfolge reichen, etwa in eine Wellenleiterschicht, in die aktive Schicht oder in das Substrat. Weiterhin kann zumindest eine zweite Vertiefung Seitenwände aufweisen, die mit der Hauptoberfläche einen Winkel größer oder gleich 90° und kleiner oder gleich 135° einschließen und mit der Hauptoberfläche somit eine rechtwinklige oder stumpfwinklige Kante bilden können. Insbesondere können die zweiten Vertiefungen gleich hinsichtlich ihrer Tiefe, Größe und Querschnittsform ausgeführt sein.

Zumindest eine zweite Vertiefung kann eine Erstreckungsrichtung aufweisen, die mit der Abstrahlrichtung einen Winkel größer als 0° und kleiner als 90° einschließen kann. Bevorzugt kann der Winkel größer oder gleich 30° und kleiner oder gleich 60° und besonders bevorzugt etwa 45° sein. Das kann bedeuten, dass die zumindest eine zweite Vertiefung einen Graben umfasst oder als Graben ausgebildet ist und schräg zur Abstrahlrichtung angeordnet ist.

Insbesondere kann das auch bedeuten, dass die zumindest eine zweite Vertiefung auch schräg zur Strahlungsauskoppelfläche angeordnet ist. Dadurch kann es möglich sein, dass elektromagnetische Strahlung, die an der Strahlungsauskoppelfläche reflektiert wird und sich als Streustrahlung in der Halbleiterschichtenfolge entgegen der Abstrahlrichtung seitlich versetzt zum aktiven Bereich ausbreiten kann, durch die zweite Vertiefung in Richtung der ersten Vertiefung reflektiert werden kann und wie oben beschrieben von dieser ebenfalls reflektiert oder auch absorbiert werden kann. Dadurch können etwaig auftretende Laseroszillationen neben dem aktiven Bereich verhindert werden, so dass in der aktiven Schicht keine Nebenmoden auftreten, die die Strahlqualität der vom aktiven Bereich erzeugten elektromagnetischen Strahlung verschlechtern könnten.

Weiterhin kann zumindest eine zweite Vertiefung wie oben im Zusammenhang mit der ersten Vertiefung beschrieben zumindest teilweise mit einem absorbierenden Material gefüllt oder beschichtet sein.

Insbesondere können die zweiten Vertiefungen gleich ausgeführt sein, wobei jeweils zwei zweite Vertiefungen symmetrisch zur Abstrahlrichtung um einen ersten Teilbereich einer elektrischen Kontaktfläche angeordnet sein können. Die zweiten Vertiefungen können dabei einen Abstand von kleiner oder gleich 4 µm von einem aktiven Bereich und/oder einer Ridge-Struktur beziehungsweise elektrischen Kontaktfläche aufweisen. Gerade dadurch, dass die zweiten Vertiefungen neben den ersten Teilbereichen der elektrischen Kontaktflächen derart angeordnet sind, dass sich die ersten Teilbereiche zwischen jeweils zwei zweiten Vertiefungen befinden, können durch die zweiten Vertiefungen Blenden in der Halbleiterschichtenfolge ermöglicht werden, die eine möglichst kleine Blendenöffnung aufweisen. Insbesondere kann es dabei vorteilhaft sein, wenn die zweiten Vertiefungen näher am zweiten Teilbereich als an der Rückseite der Halbleiterschichtenfolge angeordnet sind.

Um insbesondere die Entstehung von Streustrahlung durch Reflexion von im aktiven Bereich erzeugten kohärenten elektromagnetischen Strahlung an der Strahlungsauskoppelfläche zu vermeiden, kann die Strahlungsauskoppelfläche eine Schicht mit einer Reflektivität von kleiner oder gleich 10%, bevorzugt kleiner oder gleich 5% und besonders bevorzugt kleiner oder gleich 2% aufweisen, so dass die Strahlungsauskoppelfläche einen Transmissionskoeffizienten von größer oder gleich 90%, bevorzugt größer oder gleich 95% und besonders bevorzugt größer oder gleich 98% aufweisen kann. Insbesondere kann ein Reflexionskoeffizient von 0,1 bis 2% vorteilhaft sein. Beispielsweise kann die Schicht als Einzelschicht oder als Schichtenfolge mit Schichtenpaaren ausgeführt sein und dabei Metall- oder Halbmetalloxide und/oder Metall- oder Halbmetallnitride aufweisen. Ein Metalloxid oder ein Halbmetalloxid kann Aluminium, Silizium, Titan, Zirkonium, Tantal, Niobium, oder Hafnium aufweisen. Weiterhin kann ein Nitrid zumindest eines der genannten Metalle und Halbmetalle aufweisen, beispielsweise Siliziumnitrid. Besonders bevorzugt umfasst das Metalloxid oder das Halbmetalloxid zumindest eines der Materialien Niobiumpentoxid, Hafniumdioxid, Aluminiumoxid, Siliziumdioxid, Titandioxid, Tantalpentoxid und Zirkoniumdioxid.

Weiterhin kann die Halbleiterschichtenfolge eine Vielzahl von aktiven Bereichen mit zugehörigen elektrischen Kontaktflächen auf der Hauptoberfläche aufweisen. Das kann insbesondere bedeuten, dass die Halbleiterschichtenfolge zumindest einen weiteren aktiven Bereich und eine weitere elektrische Kontaktfläche mit einem ersten und zweiten Teilbereich aufweist, die quer zur Abstrahlrichtung neben den zumindest zwei aktiven Bereichen beziehungsweise den zugehörigen elektrischen Kontaktflächen angeordnet sind. Weiterhin kann die Halbleiterschichtenfolge auf der Hauptoberfläche zumindest eine weitere erste Vertiefung zwischen den zumindest zwei elektrischen Kontaktbereichen und dem weiteren elektrischen Kontaktbereich aufweisen. Darüber hinaus können auf der Hauptoberfläche weitere zwei zweite Vertiefungen angeordnet sein, zwischen denen der erste Teilbereich der weiteren elektrischen Kontaktfläche angeordnet ist.

Die hier beschriebene Laserlichtquelle ermöglicht eine hohe Abstrahlleistung bei gleichzeitiger hoher Strahlqualität. Im Vergleich dazu weisen bekannte Breitstreifenlaserdioden, die einen aktiven Bereich mit einer Breite in der Größenordnung von mehreren 100 µm aufweisen können, zwar eine hohe Abstrahlleistung auf, aber damit verbunden auch eine Abstrahlcharakteristik mit mehreren elektromagnetischen Moden sowie ein stark asymmetrisches Strahlprofil als Folge des asymmetrischen Strahlparameterprodukts bezüglich der Strahlachsen parallel zur Erstreckungsebene der Halbleiterschichten ("slow axis") und parallel zur Aufwachsrichtung der Halbleiterschichtenfolge ("fast axis"). Dadurch benötigt ein Breitstreifenlaser im Gegensatz zur hier beschriebenen Laserlichtquelle üblicherweise eine aufwändige und teure Optik, um die Abstrahlcharakteristik zu symmetrisieren. Die hier beschriebene Laserlichtquelle ermöglicht auch im Gegensatz zu bekannten Trapezlaserbarrenausführungen eine hohe Strahlqualität bei gleichzeitig hoher Leistung. Dabei kann die hier beschriebene Laserlichtquelle kostengünstig herstellbar sein.

Weitere Vorteile und vorteilhafte Ausführungsformen und Weiterbildungen der Erfindung ergeben sich aus den im Folgenden in Verbindung mit den Figuren 1A bis 5B beschriebenen Ausführungsformen.

Es zeigen:
Figuren 1A und 1B schematische Darstellungen einer Laserlichtquelle gemäß einem Ausführungsbeispiel,
Figuren 2A bis 2C schematische Darstellungen einer Laserlichtquelle gemäß einem weiteren Ausführungsbeispiel und
Figuren 3A bis 5B Messungen von Laserlichtquellen gemäß weiterer Ausführungsbeispiele.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

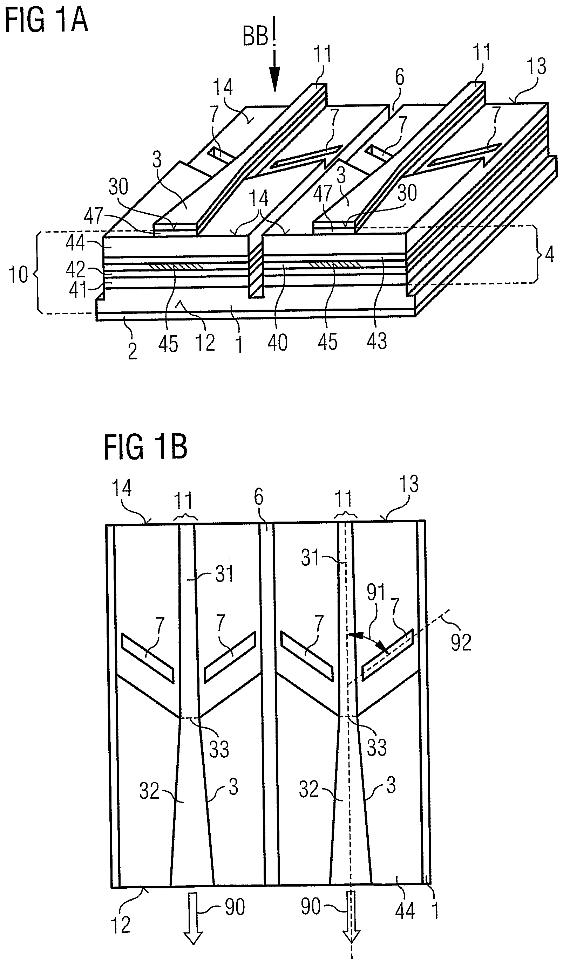

In den Figuren 1A und 1B ist ein Ausführungsbeispiel für eine Laserlichtquelle gezeigt. Die nachfolgende Beschreibung zu diesem Ausführungsbeispiel bezieht sich, soweit nicht ausdrücklich anders gekennzeichnet, gleichermaßen auf beide Figuren 1A und 1B.

Dabei zeigt Figur 1A eine schematische räumliche Darstellung der Laserlichtquelle mit einer Halbleiterschichtenfolge 10. Die Figur 1B zeigt eine Draufsicht auf die Laserlichtquelle aus der in Figur 1A mit BB gekennzeichneten Richtung.

Die Laserlichtquelle gemäß dem Ausführungsbeispiel der Figuren 1A und 1B weist eine Halbleiterschichtenfolge 10 mit einem Substrat 1 auf, auf dem eine Mehrzahl von funktionellen, epitaktisch aufgewachsenen Schichten 4 aufgebracht ist. Die Halbleiterschichtenfolge 10 wird dabei im gezeigten Ausführungsbeispiel gebildet durch ein GaAs-Substrat 1 und darüber eine 100 nm dicke Zwischenbeziehungsweise Mantelschicht 41 aus AlGaAs mit einem Al-Anteil von etwa 40% an den Gruppe-III-Materialien und/oder aus InGaP mit einem In-Anteil von etwa 50% an den Gruppe-III-Materialien, darüber eine 2 µm dicke InAlP-Wellenleiterschicht 42, darüber eine 100 nm dicke InGaAlP/InGaP-Quantenfilm/Barriereschichten-MQW-Struktur mit einem In-Anteil von etwa 50% und einem Al-Anteil von etwa 25%, darüber eine 2 µm dicke InAlP-Wellenleiterschicht 43 sowie darüber eine 100 nm dicke InGaP-Zwischenbeziehungsweise Mantelschicht 44. Zusätzlich ist auf der Mantelschicht 44 eine Kontaktschicht, etwa eine 300 nm dicke GaAs-Kontaktschicht 47, angeordnet. Eine derartige Halbleiterschichtenfolge 10 kann geeignet sein, gelbe bis infrarote elektromagnetische Strahlung zu erzeugen und besonders bevorzugt elektromagnetische Strahlung in einem roten Wellenlängenbereich.

Alternativ zu den hier beschriebenen Arsenid-basierten Halbleitermaterialien kann die Halbleiterschichtenfolge 10 beispielsweise auch Nitrid-basierte Halbleitermaterialien aufweisen. Eine derartige Halbleiterschichtenfolge 10 kann geeignet sein, elektromagnetische Strahlung in einem ultravioletten bis grünen und bevorzugt in einem blauen Wellenlängenbereich zu erzeugen.

Das Substrat 1 kann dabei ein Aufwachssubstrat sein, auf dem die funktionalen Schichten epitaktisch aufgewachsen werden. Alternativ dazu kann die Halbleiterschichtenfolge in Dünnfilm-Technologie herstellbar sein. Das bedeutet, dass die funktionalen Schichten auf einem Aufwachssubstrat aufgewachsen und anschließend auf ein Trägersubstrat, das dann das Substrat 1 der Halbleiterschichtenfolge 10 bildet, übertragen wird. Je nach Aufwachstechnik können dabei die n-leitenden Schichten oder die p-leitenden Schichten der Halbleiterschichtenfolge 10 dem Substrat 1 zugewandt sein.

Weiterhin weist die Halbleiterschichtenfolge 10 eine Strahlungsauskoppelfläche 12 und eine dazu gegenüberliegende als Rückseite ausgebildete Oberfläche 13 auf, die jeweils eine zumindest teilweise reflektierende Beschichtung aufweisen (nicht gezeigt). Dadurch bilden die Strahlungsauskoppelfläche 12 und die Rückseite 13 einen optischen Resonator. Die jeweilige reflektierende Beschichtung kann beispielsweise eine Bragg-Spiegel-Schichtenfolge und/oder reflektierende Metallschichten umfassen.

Auf oder über den Oberflächen der Halbleiterschichtenfolge, die verschieden von der Strahlungsauskoppelfläche sind, können weiterhin Passivierungsschichten zum Schutz der Halbleiterschichtenfolge aufgebracht sein (nicht gezeigt).

Die elektrische Kontaktierung der Halbleiterschichtenfolge 10 erfolgt über eine Elektrode 2 auf der den funktionellen Schichten 4 abgewandten Oberfläche des Substrats 1 und über Elektrodenstreifen 3 auf der dem Substrat 1 gegenüberliegenden Hauptoberfläche 14 der funktionellen Schichten 4. Die Elektroden 2 und 3 können dabei jeweils eine oder mehrere Metallschichten mit Ag, Au, Sn, Ti, Pt, Pd und/oder Ni aufweisen.

Alternativ zur elektrischen Kontaktierung durch die Elektrode 2 durch das Substrat 1 hindurch kann der elektrische Kontakt 2 auch auf derselben Seite der Substrats 1 wie die funktionellen Schichten 4 angeordnet sein. Diese Kontaktierungsart ist vor allem geeignet, die funktionalen Schichten 4 von der Substratseite elektrisch zu kontaktieren, wenn diese auf einem elektrisch nicht leitfähigen Substrat 1 angeordnet sind.

Die Kontaktflächen zwischen den Elektrodenstreifen 3 und der Mantelschicht 44 sind als elektrische Kontaktflächen 30 ausgebildet.

Wie in Figur 1B gekennzeichnet, weisen die elektrischen Kontaktflächen 30 jeweils einen ersten Teilbereich 31 und daran angrenzend einen zweiten Teilbereich 32 auf. Die gedachte Grenzlinie zwischen dem ersten und zweiten Teilbereich ist jeweils durch die Linie 33 angedeutet. Die zweiten Teilbereiche 32 weisen eine sich entlang der Abstrahlrichtung 90 zur Strahlungsauskoppelfläche 12 hin vergrößernde Breite auf. Die Teilbereiche 32 sind dabei trapezförmig ausgeführt und ermöglichen eine Verstärkung der Leistung der in den aktiven Bereichen 45 erzeugten elektromagnetischen Strahlung.

Die Mantelschicht 44 ist im gezeigten Ausführungsbeispiel im Bereich der elektrischen Kontaktflächen 30 im ersten Teilbereich 31 stegförmig ausgeführt und bildet mit der Kontaktschicht 47 eine so genannte Ridge-Struktur oder Steg-Struktur 11 wie im allgemeinen Teil beschrieben, wobei die Oberseite der Ridge-Strukturen 11 als Teil der Hauptoberfläche 14 die elektrischen Kontaktflächen 30 bilden. Im zweiten Teilbereich 32 ist lediglich die Kontaktschicht 47 stegförmig ausgebildet, so dass die Ridge-Strukturen im ersten Teilbereich 31 eine größere Tiefe aufweisen wie im zweiten Teilbereich. Die Ridge-Strukturen 11 weisen hinsichtlich ihrer Form dieselbe Form wie die elektrischen Kontaktflächen 30 auf.

Durch die Ridge-Strukturen 11 kann in der aktiven Schicht 40 die Ausbildung von kohärenter elektromagnetischer Strahlung in einer transversalen Grundmode ermöglicht werden, wohingegen unerwünschte weitere Lasermoden unterdrückt werden können. Dadurch weist die aktive Schicht 40 unterhalb der elektrischen Kontaktflächen 30 und der Ridge-Strukturen 11 aktive Bereiche 45 auf, die unter anderem durch die Abmessungen der elektrischen Kontaktflächen 30 und der Ridge-Strukturen 11 vorgegeben sind und im gezeigten Ausführungsbeispiel durch die schraffierten Flächen in der aktiven Schicht 40 angedeutet sind. Die aktiven Bereiche 45 erstrecken sich dabei über die gesamte Länge der aktiven Schicht 40 in dem durch die Strahlungsauskoppelfläche 12 und die Rückseite 13 gebildeten Resonator. In den aktiven Bereichen 45 kann die Halbleiterschichtenfolge 10 im Betrieb durch stimulierte Emission kohärente elektromagnetische Strahlung erzeugen, die über die Strahlungsauskoppelfläche 12 entlang der mit 90 gekennzeichneten Abstrahlrichtung jeweils als Strahlenbündel abgestrahlt werden kann.

Zwischen den elektrischen Kontaktflächen 30 weist die Hauptoberfläche 14 als Teil einer Oberflächenstruktur eine erste Vertiefung 6 auf, die sich entlang der Abstrahlrichtung 90 über die Hauptoberfläche 14 erstreckt. Die erste Vertiefung 6 ist dabei als Graben ausgeführt, der von der Hauptoberfläche 14 bis in das Substrat 1 reicht. Die erste Vertiefung 6 im gezeigten Ausführungsbeispiel weist dabei Seitenwände auf, die senkrecht zur Hauptoberfläche 14 sind und mit der Hauptoberfläche 14 jeweils rechtwinklige Kanten bilden. Die erste Vertiefung 6 erstreckt sich dabei von der Strahlungsauskoppelfläche 12 bis zur Rückseite 13 der Halbleiterschichtenfolge 10.

Durch die erste Vertiefung 6 ist die direkte Ausbreitung von Streustrahlung von einem aktiven Bereich 45 zum anderen aktiven Bereich 45 in der Halbleiterschichtenfolge nicht mehr möglich, so dass die beiden aktiven Bereiche 45 optisch entkoppelt sind. Weiterhin kann die erste Vertiefung zumindest an den Seitenwände eine Schicht mit einem absorbierenden Material aufweisen (nicht gezeigt), die etwa Germanium aufweisen kann. Um einen elektrischen Kurzschluss der funktionalen Schichten 4 zu vermeiden, kann zwischen den Seitenwänden der ersten Vertiefung 6 und der Schicht mit dem absorbierenden Material eine dielektrische Schicht, etwa Siliziumoxid, angeordnet sein.

Weiterhin umfasst die Oberflächenstruktur auf der Hauptoberfläche 14 zweite Vertiefungen 7, wobei jeder der ersten Teilbereich 31 der elektrischen Kontaktflächen 30 zwischen zwei zweiten Vertiefungen 7 angeordnet ist. Die zweiten Vertiefungen 7 weisen dabei jeweils eine Erstreckungsrichtung 92 auf, die mit der Abstrahlrichtung 90 einen Winkel 91 von etwa 45° einschließen, wie exemplarisch an einer zweiten Vertiefung 7 gekennzeichnet ist. Jeweils zwei der zweiten Vertiefungen 7 sind dabei symmetrisch um die Abstrahlrichtung 90 und jeweils einen ersten Teilbereich 31 angeordnet. Die zweiten Vertiefungen 7 reichen wie die erste Vertiefung 6 von der Hauptoberfläche 14 in das Substrat 1.

Streustrahlung, die sich beispielsweise durch die Reflexion von in den aktiven Bereichen 45 erzeugter elektromagnetischer Strahlung an der Strahlungsauskoppelfläche 12 entgegen der Abstrahlrichtung 90 seitlich versetzt zu den aktiven Bereichen 45 in der Halbleiterschichtenfolge 10 ausbreiten kann, kann an den zweiten Vertiefungen 7 zur ersten Vertiefung 6 beziehungsweise zu Seitenflächen der Halbleiterschichtenfolge 10 reflektiert werden. Dadurch kann die Ausbildung von elektromagnetischen Nebenmoden zwischen der Strahlungsauskoppelfläche 12 und der Rückseite 13 verhindert werden. Zusätzlich können die zweiten Vertiefungen 7 wie die erste Vertiefung 6 mit einem absorbierenden Material zumindest teilweise gefüllt sein.

Zur Verminderung von an der Strahlungsauskoppelfläche 12 reflektierter Streustrahlung kann auf der Strahlungsauskoppelfläche 12 eine reflexionsmindernde Schicht oder Schichtenfolge aufgebracht sein (nicht gezeigt), die einen Reflexionskoeffizienten von weniger als 2%, besonders bevorzugt weniger als 1% aufweist.

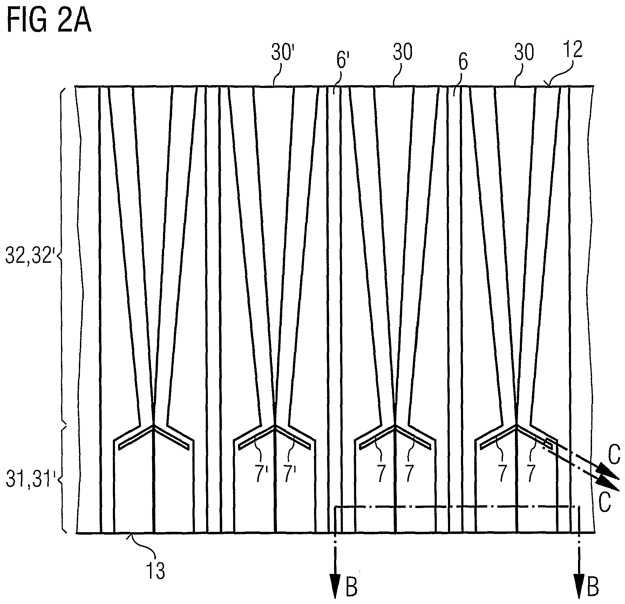

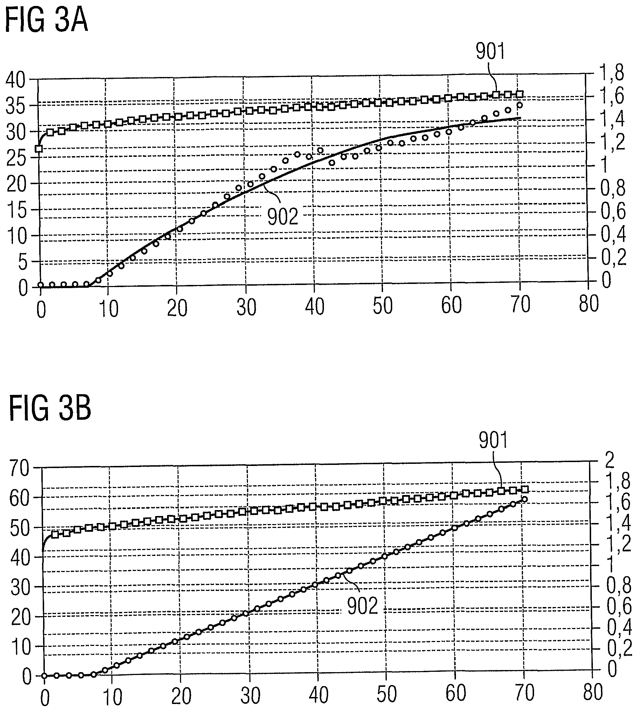

In den Figuren 3A bis 3C ist ein weiteres Ausführungsbeispiel für eine Laserlichtquelle gezeigt, das eine Modifikation des vorher gezeigten Ausführungsbeispiels darstellt. Die nachfolgende Beschreibung bezieht sich, soweit nicht ausdrücklich anders gekennzeichnet, gleichermaßen auf alle Figuren 2A bis 2C. Dabei werden insbesondere die Unterschiede und Weiterentwicklungen im Vergleich zum vorhergehenden Ausführungsbeispiel beschrieben.

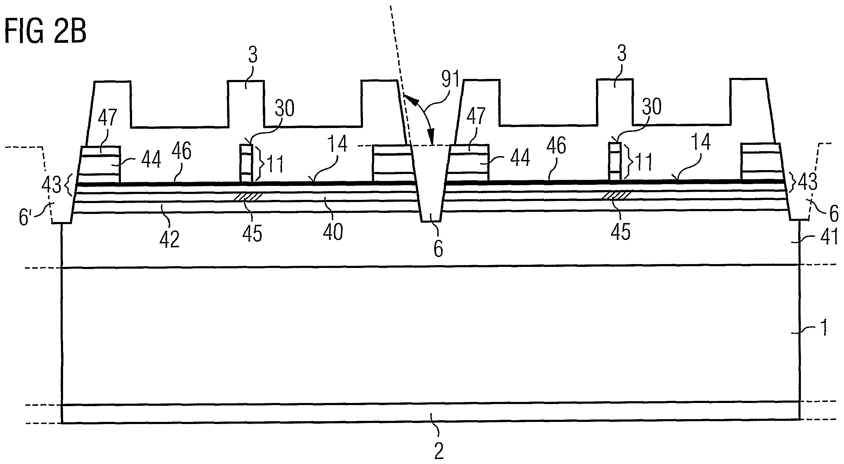

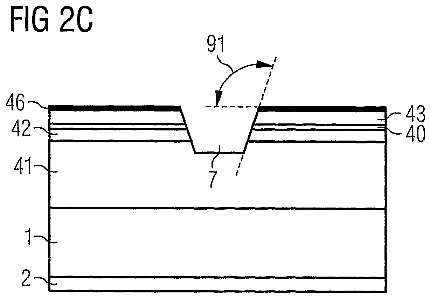

Dabei zeigt Figur 2A wie die vorhergehende Figur 1B eine Draufsicht auf die Laserlichtquelle. Die Figuren 2B und 2C zeigen Schnittansichten durch die Laserlichtquelle entlang der in Figur 2A mit BB und CC gekennzeichneten Schnittebenen.

Die Laserlichtquelle gemäß dem Ausführungsbeispiel der Figuren 2A bis 2C weist eine Mehrzahl von aktiven Bereichen sowie eine Mehrzahl von elektrischen Kontaktflächen 30 auf. In Figur 2A ist dazu exemplarisch zu den zwei elektrischen Kontaktflächen 30 die weitere elektrische Kontaktfläche 30' gezeigt. Die weitere elektrische Kontaktfläche 30' weist einen ersten Teilbereich 31' und einen zweiten Teilbereich 32' auf, die wie die ersten und zweiten Teilbereich 31, 32 der elektrischen Kontaktflächen 30 geformt sind.

Zwischen den elektrischen Kontaktflächen 30 und der weiteren elektrischen Kontaktfläche 30' ist eine weitere erste Vertiefung 6 angeordnet, die in ihrer Ausgestaltung der ersten Vertiefung 6 zwischen den zwei elektrischen Kontaktflächen 30 entspricht. Der erste Teilbereich 31' der weiteren elektrischen Kontaktfläche 30' ist weiterhin zwischen zwei weiteren zweiten Vertiefungen 7' angeordnet, die wie die zweiten Vertiefungen 7 ausgeführt sind.

Wie aus der Schnittansicht BB der Figur 2B erkennbar ist, weisen die ersten Vertiefungen 6, 6' einen V-förmigen Querschnitt auf. Das bedeutet, dass die ersten Vertiefungen 6, 6' Seitenwände aufweisen, die mit der Hauptoberfläche 14 einen Winkel 91 einschließen, der größer als 90° ist und damit eine stumpfwinklige Kante mit der Hauptoberfläche 14 bilden. Dadurch ist es möglich, dass Streustrahlung durch die ersten Vertiefungen 6, 6', die sich in der Halbleiterschichtenfolge 10 beispielsweise entlang der aktiven Schicht 40 ausbreitet, in Richtung des Substrats 1 reflektiert werden kann. Das Substrat 1, die Elektrode 2 oder eine zusätzliche Schicht der Halbleiterschichtenfolge 10 (nicht gezeigt) kann beispielsweise absorbierend sein, so dass eine weitere Ausbreitung der Streustrahlung verhindert werden kann.

Wie aus der Schnittansicht CC der Figur 2C erkennbar ist, weisen auch die zweiten Vertiefungen 7, 7' eine V-förmigen Querschnitt auf. Die Seitenwände der zweiten Vertiefungen 7, 7' schließen dabei mit der Hauptoberfläche 14 im gezeigten Ausführungsbeispiel einen Winkel von etwa 135° ein, was einer Neigung von etwa 45° zur Aufwachsrichtung der Halbleiterschichtenfolge 10 entspricht.

Die Halbleiterschichtenfolge 10 weist neben der in Zusammenhang mit dem vorhergehenden Ausführungsbeispiel in der Wellenleiterschicht 43, die zwischen der aktiven Schicht 40 und der Hauptoberfläche 14 angeordnet ist, eine Ätzstoppschicht 46 aus InGaP auf. Durch die Ätzstoppschicht 46 ist wie im allgemeinen Teil beschrieben eine genau definierte Höhe der Ridge-Strukturen 11 herstellbar, wodurch die Strahlqualität der von den aktiven Bereichen abgestrahlten elektromagnetischen Strahlung verbessert werden kann.

Über der Mantelschicht 44 ist eine GaAs-Kontaktschicht 47 angeordnet, die an den elektrischen Kontaktflächen 30 einen ohmschen Kontakt mit einem niedrigen Übergangswiderstand zur großflächig aufgebrachten Elektrode 3 ermöglicht. Um eine Strominjektion lediglich über die elektrischen Kontaktflächen 30 und damit die Ausbildung genau definierter aktiver Bereiche 45 zu ermöglichen, kann auf der gesamten Hauptoberfläche 14 bis auf die elektrischen Kontaktflächen 30 eine dielektrische Schicht, etwa Siliziumdioxid, aufgebracht sein (nicht gezeigt).

In den folgenden Figuren 3A bis 5B sind Messungen mit einer Laserlichtquelle gemäß dem Ausführungsbeispiel der Figuren 2A bis 2C im Vergleich zu einer Vergleichslaserlichtquelle gezeigt, die die vorteilhafte Wirkungsweise der hier beschriebenen Oberflächenstruktur mit ersten und zweiten Vertiefungen zeigen.

In den Figuren 3A und 3B sind Leistungskennlinien für eine Vergleichslaserlichtquelle (Figur 3A) und eine Laserlichtquelle gemäß einem Ausführungsbeispiel (Figur 3B) gezeigt. Die Abszisse zeigt dabei den der Vergleichslaserlichtquelle beziehungsweise der Laserlichtquelle aufgeprägten Strom im Ampere. Die Kurven 901 (quadratische Symbole) zeigen in Verbindung mit der rechten Ordinate die dazu erforderliche Spannung in Volt, während die Kurven 902 (Rautensymbole) jeweils in Verbindung mit der linken Ordinate die abgestrahlte Leistung in Watt anzeigen.

Die der Messung in Figur 3B zugrunde liegende Laserlichtquelle ist dabei wie im vorangegangenen Ausführungsbeispiel beschrieben ausgeführt und weist eine Gesamtbreite von 1 cm auf. Die zweiten Teilbereiche weisen einen Öffnungswinkel von 4° auf. Die ersten Teilbereiche weisen eine Breite von 4 µm auf, die sich in den zweiten Teilbereichen auf eine Breite von 100 µm an der Strahlungsauskoppelfläche 12 vergrößert. Die Strahlungsauskoppelfläche 12 ist mit einer reflexionsmindernden Schicht mit einer Reflektivität von 1% beschichtet. Die abgestrahlte elektromagnetische Strahlung weist eine Wellenlänge von 940 nm auf. Die ersten Vertiefungen 6 weisen kein absorbierendes Material auf.

Die Vergleichslaserlichtquelle weist im Gegensatz dazu keine ersten Vertiefungen 6 und damit keine optische Entkopplung der aktiven Bereiche 45 auf. Die zweiten Teilbereiche der Vergleichslaserlichtquelle weisen einen Öffnungswinkel von 3° auf.

Hinsichtlich der abgestrahlten Leistung sind für die Vergleichslaserlichtquelle deutlich ein Sättigungsverhalten sowie durch Rückkoppeleffekte und optisches Übersprechen hervorgerufene Stufen in der Leistungskennlinie 902 zu erkennen. Die maximal abgestrahlte Leistung erreicht bei einem Strom von 70 A etwa 34 W. Im Gegensatz dazu weist die Leistungskennlinie 902 der Laserlichtquelle gemäß dem hier beschriebenen Ausführungsbeispiel einen linearen Verlauf und eine Leistung von etwa 58 W bei einem Strom von 70 A auf.

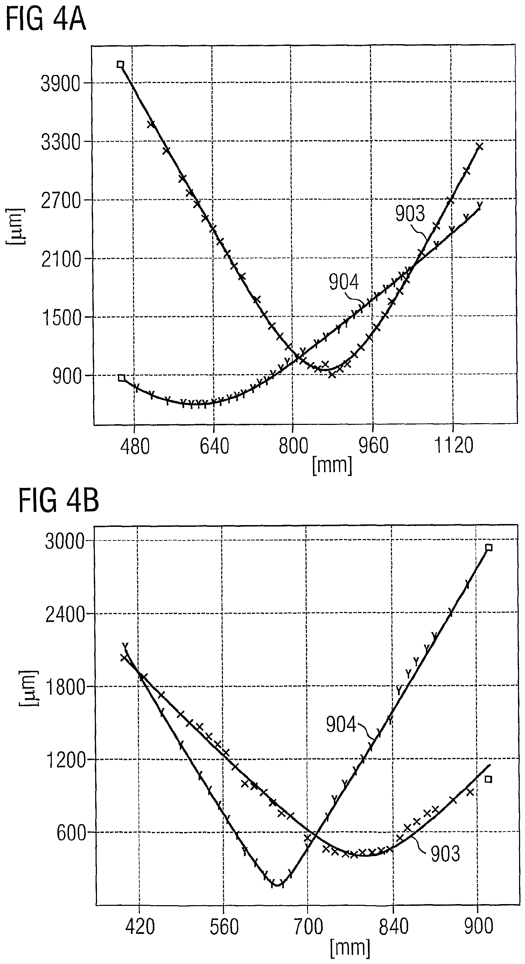

In den Figuren 4A und 4B sind Strahlkaustiken für eine Vergleichslaserlichtquelle (Figur 4A) und eine Laserlichtquelle gemäß einem Ausführungsbeispiel (Figur 4B) gezeigt. Die Abszissen zeigen dabei jeweils den Abstand von der Strahlungsauskoppelfläche 12 in Abstrahlrichtung 90 in Millimeter, während die Ordinaten jeweils einen Abstand zum Strahlzentrum in Mikrometer zeigen. Die Kurven 903 zeigen dabei Linien gleich Intensität in einer Strahlmittelebene parallel zur Erstreckungsebene der Halbleiterschichtenfolge 10 ("x-Richtung"), während die Kurven 904 Linien gleich Intensität in einer Strahlmittelebene senkrecht dazu ("y-Richtung") zeigen. Die Messungen wurden dabei mit mittels eines Spiricon Beam Propagation Analyzer durchgeführt.

Im Gegensatz zur Messung in den Figuren 3A und 3B weist die Vergleichslaserlichtquelle in dieser Messung weder erste noch zweite Vertiefungen auf.

Insbesondere zeigen die Kurven 903 und 904 die laterale Position zum Strahlmittelpunkt in x- und y-Richtung, bei der eine vorgegebene Intensität erreicht wird. Aus der Steigung der Kurven sowie dem jeweiligen Minimum, das den Abstand der Strahltaille zum Strahlmittelpunkt angibt, lässt sich die dem Fachmann bekannte Beugungsmaßzahl M² ermitteln. Für die Vergleichslaserlichtquelle beträgt M² in x-Richtung etwa 7, während M² für die Laserlichtquelle gemäß dem Ausführungsbeispiel in x-Richtung etwa 2,2 beträgt.

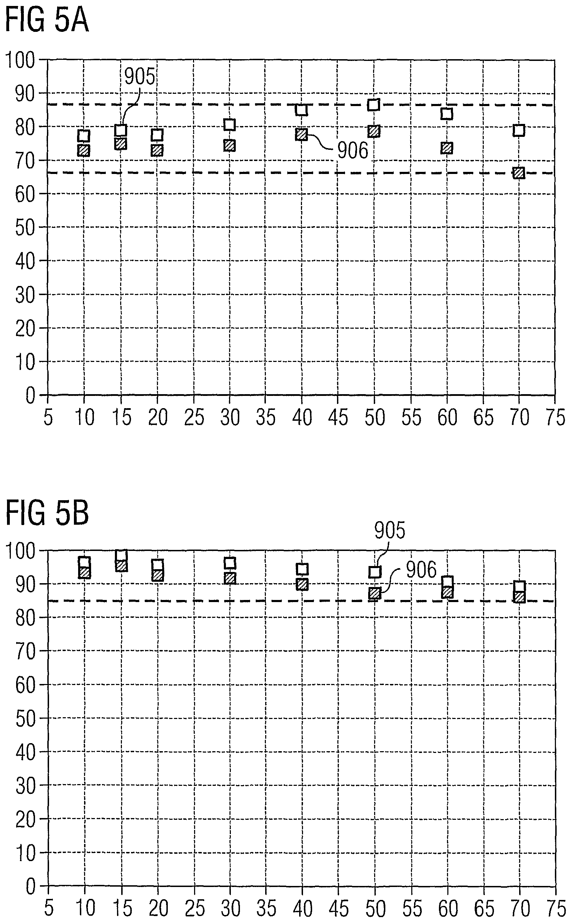

In den Figuren 5A und 5B sind Einkoppeleffizienzen für eine Vergleichslaserlichtquelle (Figur 5A) und eine Laserlichtquelle gemäß einem Ausführungsbeispiel (Figur 5B) gezeigt. Die Vergleichslaserlichtquelle weist bei dieser Messung wiederum keine ersten und zweiten Vertiefungen auf. Die Abszissen zeigen jeweils den aufgeprägten Strom in Ampere. Die Punkte 905 (offene Quadrate) zeigen die Einkoppeleffizienz (in %) der von der Vergleichslaserlichtquelle beziehungsweise Laserlichtquelle abgestrahlten elektromagnetischen Strahlung in eine optische Faser mit einem Durchmesser von 600 µm und einer numerischen Apertur (NA) von 0,2. Die Punkte 906 (volle Quadrate) zeigen die Einkoppeleffizienz (in %) der von der Vergleichslaserlichtquelle beziehungsweise Laserlichtquelle abgestrahlten elektromagnetischen Strahlung in eine optische Faser mit einem Durchmesser von 400 µm und einer NA von 0,2.

Während sich aus der Messung in Figur 5A für die Vergleichslaserlichtquelle ohne erste und zweite Vertiefungen bei einem Strom von 70 A für die 600 µm-Faser eine Einkoppeleffizienz von etwa 79% und für die 400 µm-Faser eine Einkoppeleffizienz von etwa 66% ergibt, können mit der Laserlichtquelle gemäß dem Ausführungsbeispiel entsprechende Einkoppeleffizienzen von 89% für die 600 µm-Faser und 86% für die 40 µm-Faser erreicht werden. Dabei sind jeweils Verluste an den Linsenoberflächen der Einkoppeloptiken berücksichtigt.

Weiterhin wurden Messungen durchgeführt, bei denen Vergleichslaserlichtquellen mit verschiedenen Öffnungswinkeln in den zweiten Teilbereichen verwendet wurden. Im Mittel wird mit diesen Vergleichslaserlichtquellen bei einem Strom von 70 A eine Einkoppeleffizienz von etwa 75% in eine 400 µm-Faser erreicht, die der in Figur 5B gezeigten Einkoppeleffizienz 906 von 86% gegenüberzustellen ist.

Aus den hier gezeigten und beschriebenen Messungen geht deutlich hervor, dass gerade durch die Kombination der ersten und zweiten Vertiefungen eine hohe Abstrahlleistung bei gleichzeitiger hoher Strahlqualität ermöglicht werden kann.

Weiterhin ist eine Stapelung zweiter oder mehrerer der gezeigten Laserlichtquellen möglich, um eine Erhöhung der abgestrahlten Leistung zu erreichen. Dabei sind bei kohärenter Kopplung Leistungen von etwa 1000 W pro Stapel, bei inkohärenter Kopplung Leistungen von etwa 3000 W möglich.

## Patentansprüche

1. Laserlichtquelle, umfassend
- eine Halbleiterschichtenfolge (10) mit einer aktiven Schicht mit zumindest zwei aktiven Bereichen (45), die geeignet sind, im Betrieb elektromagnetische Strahlung über eine als Strahlungsauskoppelfläche (12) ausgeführte Seitenfläche der Halbleiterschichtenfolge (10) entlang einer Abstrahlrichtung (90) abzustrahlen,
- jeweils eine elektrische Kontaktfläche (30) über jedem der zumindest zwei aktiven Bereiche (45) auf einer Hauptoberfläche (14) der Halbleiterschichtenfolge (10) und
- eine Oberflächenstruktur in der Hauptoberfläche (14) der Halbleiterschichtenfolge (10),
wobei
- die zumindest zwei aktiven Bereiche (45) quer zur Abstrahlrichtung (90) zueinander beabstandet in der aktiven Schicht (40) angeordnet sind,
- jede der elektrischen Kontaktflächen (30) einen ersten Teilbereich (31) aufweist und einen zweiten Teilbereich (32) mit einer sich entlang der Abstrahlrichtung (90) zur Strahlungsauskoppelfläche (12) hin vergrößernden Breite,
- die Oberflächenstruktur zwischen den zumindest zwei elektrischen Kontaktflächen (30) zumindest eine erste Vertiefung (6) entlang der Abstrahlrichtung (90) sowie zweite Vertiefungen (7) aufweist,
- die ersten Teilbereiche (31) der elektrischen Kontaktflächen (30) jeweils zwischen zumindest zwei zweiten Vertiefungen (7) angeordnet sind,
- die Hauptoberfläche (14) stegförmige Strukturen (11) in der Halbleiterschichtenfolge aufweist auf denen jeweils der erste und der zweite Teilbereich (31, 32) der elektrischen Kontaktflächen (30) angeordnet sind, und
- jede der stegförmigen Strukturen (11) im ersten Teilbereich (31) eine erste Tiefe aufweist, die größer als eine zweite Tiefe der stegförmigen Struktur (11) im zweiten Teilbereich (32) ist.

2. Laserlichtquelle nach Anspruch 1, wobei
- die zweiten Teilbereiche (32) jeweils eine Trapezform aufweisen und jeweils an die Strahlungsauskoppelfläche (12) angrenzen.

3. Laserlichtquelle nach einem der vorherigen Ansprüche, wobei
- die ersten Teilbereiche (31) sich jeweils mit einer gleich bleibenden Breite auf der Hauptoberfläche (14) entlang der Abstrahlrichtung (90) erstrecken.

4. Laserlichtquelle nach einem der vorherigen Ansprüche, wobei
- die aktive Schicht (40) zwischen zwei Wellenleiterschichten (42, 43) auf einem Substrat (1) angeordnet ist und die erste Vertiefung (6) von der Hauptoberfläche (14) bis in zumindest eine Schicht ausgewählt aus der aktiven Schicht (40), den Wellenleiterschichten (42, 43) und dem Substrat (1) reicht.

5. Laserlichtquelle nach einem der vorherigen Ansprüche, wobei
- die erste Vertiefung (6) sich auf der Hauptoberfläche (14) von der Strahlungsauskoppelfläche (12) bis zu einer der Strahlungsauskoppelfläche (12) gegenüberliegenden Seitenfläche (13) der Halbleiterschichtenfolge (10) erstreckt.

6. Laserlichtquelle nach einem der vorherigen Ansprüche, wobei
- die erste Vertiefung (6) zumindest einen Graben parallel zur Abstrahlrichtung (90) aufweist.

7. Laserlichtquelle nach einem der vorherigen Ansprüche, wobei
- die erste Vertiefung (6) Seitenwände aufweist, die mit der Hauptoberfläche (14) einen Winkel größer oder gleich 90° einschließen.

8. Laserlichtquelle nach einem der vorherigen Ansprüche, wobei
- in der ersten Vertiefung (6) und/oder in der zweiten Vertiefung (7) ein absorbierendes Material angeordnet ist.

9. Laserlichtquelle nach einem der vorherigen Ansprüche, wobei
- zumindest eine zweite Vertiefung (7) eine Erstreckungsrichtung (92) aufweist, die mit der Abstrahlrichtung (90) einen Winkel größer als 0° und kleiner oder gleich 90° einschließt.

10. Laserlichtquelle nach einem der vorherigen Ansprüche, wobei
- zumindest eine zweite Vertiefung (7) einen Abstand zu einer elektrischen Kontaktfläche (30) von kleiner oder gleich 4 µm aufweist.

11. Laserlichtquelle nach einem der vorherigen Ansprüche, wobei
- die aktive Schicht (40) zwischen zwei Wellenleiterschichten (42, 43) auf einem Substrat (1) angeordnet ist und zumindest eine zweite Vertiefung (7) von der Hauptoberfläche (14) bis in zumindest eine Schicht ausgewählt aus der aktiven Schicht (40), den Wellenleiterschichten (42, 43) und dem Substrat (1) reicht.

12. Laserlichtquelle nach einem der vorherigen Ansprüche, wobei
- zumindest eine zweite Vertiefung (7) Seitenwände aufweist, die mit der Hauptoberfläche (14) einen Winkel größer oder gleich 90° einschließen.

13. Laserlichtquelle nach einem der vorherigen Ansprüche, wobei die erste Tiefe eine Indexführung und die zweite Tiefe eine Gewinnführung bewirkt, wobei
- die erste Tiefe bis zu einer Wellenleiterschicht (43) der Halbleiterschichtenfolge (10) reicht und die zweite Tiefe bis zu einer über der Wellenleiterschicht (43) angeordneten Halbleiterkontaktschicht (47) oder Mantelschicht (44) reicht oder
- die erste Tiefe bis in eine Mantelschicht (44) reicht und die zweite Tiefe bis zu einer Grenzfläche zwischen der Mantelschicht (44) und einer darüber angeordneten Halbleiterkontaktschicht (47) oder nur bis in die Halbleiterkontaktschicht (47) reicht.

14. Laserlichtquelle nach dem vorherigen Anspruch, wobei
- die Hauptoberfläche (14) eine Ätzstoppschicht (46) umfasst, die an die stegförmigen Strukturen (11) angrenzt.

15. Laserlichtquelle nach einem der vorherigen Ansprüche, wobei
- die Halbleiterschichtenfolge (10) beabstandet zu den zumindest zwei aktiven Bereichen (45) zumindest einen weiteren aktiven Bereich in der aktiven Schicht (40) umfasst,
- die Hauptoberfläche (14) eine weitere elektrische Kontaktfläche (30') mit einem ersten und zweiten Teilbereich (31', 32') über dem weiteren aktiven Bereich aufweist
- die Oberflächenstruktur zumindest eine weitere erste Vertiefung (6') entlang der Abstrahlrichtung (90) aufweist, die zwischen den zumindest zwei elektrischen Kontaktflächen (30) und der weiteren elektrischen Kontaktfläche (30') angeordnet ist, und
- die Oberflächenstruktur zwei weitere zweite Vertiefungen (7') aufweist, zwischen denen der erste Teilbereich (31') der weiteren elektrischen Kontaktfläche (30') angeordnet ist.

## Claims

1. Laser light source, comprising
- a semiconductor layer sequence (10) having an active layer having at least two active regions (45) which are suitable for emitting electromagnetic radiation during operation via a side area of the semiconductor layer sequence (10) along an emission direction (90), said side area being embodied as a radiation coupling-out area (12),
- a respective electrical contact area (30) above each of the at least two active regions (45) on a main surface (14) of the semiconductor layer sequence (10), and
- a surface structure in the main surface (14) of the semiconductor layer sequence (10),
wherein
- the at least two active regions (45) are arranged in a manner spaced apart from one another in the active layer (40) transversely with respect to the emission direction (90),
- each of the electrical contact areas (30) has a first partial region (31) and a second partial region (32) having a width that increases along the emission direction (90) toward the radiation coupling-out area (12),
- the surface structure has, between the at least two electrical contact areas (30), at least one first depression (6) along the emission direction (90) and also second depressions (7),
- the first partial regions (31) of the electrical contact areas (30) are in each case arranged between at least two second depressions (7),
- in the semiconductor layer sequence the main surface (14) has ridge-type structures (11), on which the first partial region and second partial region (31, 32) of the electrical contact areas (30) are arranged, respectively, and
- each of the ridge-type structures (11) has a first depth in the first partial region (31), which is greater than a second depth of the ridge-type structure (11) in the second partial region (32).

2. The laser light source according to claim 1, wherein
- the second partial regions (32) in each case have a trapezoidal form and in each case adjoin the radiation coupling-out area (12).

3. The laser light source according to either of the preceding claims, wherein
- the first partial regions (31) in each case extend with a constant width on the main surface (14) along the emission direction (90).

4. The laser light source according to any of the preceding claims, wherein
- the active layer (40) is arranged between two waveguide layers (42, 43) on a substrate (1) and the first depression (6) extends from the main surface (14) into at least one layer selected from the active layer (40), the waveguide layers (42, 43) and the substrate (1).

5. The laser light source according to any of the preceding claims, wherein
- the first depression (6) extends on the main surface (14) from the radiation coupling-out area (12) to a side area (13) of the semiconductor layer sequence (10), said side area lying opposite the radiation coupling-out area (12) .

6. The laser light source according to any of the preceding claims, wherein
- the first depression (6) has at least one trench parallel to the emission direction (90).

7. The laser light source according to any of the preceding claims, wherein
- the first depression (6) has sidewalls which form an angle of greater than or equal to 90° with the main surface (14).

8. The laser light source according to any of the preceding claims, wherein
- an absorbent material is arranged in the first depression (6) and/or in the second depression (7).

9. The laser light source according to any of the preceding claims, wherein
- at least one second depression (7) has an extension direction (92) which forms an angle of greater than 0° and less than or equal to 90° with the emission direction (90).

10. The laser light source according to any of the preceding claims, wherein
- at least one second depression (7) is at a distance of less than or equal to 4 µm from an electrical contact area (30).

11. The laser light source according to any of the preceding claims, wherein
- the active layer (40) is arranged between two waveguide layers (42, 43) on a substrate (1) and at least one second depression (7) extends from the main surface (14) right into at least one layer selected from the active layer (40), the waveguide layers (42, 43) and the substrate (1).

12. The laser light source according to any of the preceding claims, wherein
- at least one second depression (7) has sidewalls which form an angle of greater than or equal to 90° with the main surface (14).

13. The laser light source according to any of the preceding claims, wherein the first depth provides a index guidance and the second depth provides a gain guidance, wherein
- the first depth extends as far as a waveguide layer (43) and the second depth extends as far as a semiconductor contact layer (47) or cladding layer (44) arranged above the waveguide layer (43) or
- the first depth extends into a cladding layer (44) and the second depth extends as far as an interface between the cladding layer (44) and a semiconductor contact layer (47) arranged thereabove or even only into the semiconductor contact layer (47).

14. The laser light source according to the preceding claim, wherein
- the main surface (14) comprises an etching stop layer (46), which adjoins the ridge-type structures (11).

15. The laser light source according to any of the preceding claims, wherein
- the semiconductor layer sequence (10) comprises, at a distance from the at least two active regions (45), at least one further active region in the active layer (40),
- the main surface (14) has a further electrical contact area (30') having a first and second partial region (31', 32') above the further active region,
- the surface structure has at least one further first depression (6') along the emission direction (90), which is arranged between the at least two electrical contact areas (30) and the further electrical contact area (30'), and
- the surface structure has two further second depressions (7') between which the first partial region (31') of the further electrical contact area (30') is arranged.

## Revendications

1. Source de lumière laser, comprenant
- une séquence de couches semi-conductrices (10) comportant une couche active qui comporte au moins deux zones actives(45) aptes à émettre en service un rayonnement électromagnétique moyennant une face latérale de la séquence de couches semi-conductrices (10) conçue sous forme de surface de découplage de rayonnement (12) selon une direction de rayonnement (90),
- une surface de contact électrique (30) chacune disposée au-dessus des au moins deux zones actives (45) sur une surface principale (14) de la séquence de couches semi-conductrices (10), et
- une structure de surface prévue dans la surface principale (14) de la séquence de couches semi-conductrices (10),
- les au moins deux zones actives (45) étant disposées dans la couche active (40) de manière espacée l'une par rapport à l'autre et perpendiculairement à la direction de rayonnement (90),
- chacune des surfaces de contact électrique (30) présentant une première section partielle (31) et une seconde section partielle (32) ayant une largeur augmentant le long de la direction de rayonnement (90) vers la surface de découplage du rayonnement,
- la structure surfacique présentant, entre les au moins deux surfaces de contact (30) électrique, au moins un premier évidement (6) le long de la direction d'émission (90) ainsi que des seconds évidements (7),
- les premières sections partielles (31) des surfaces de contact électriques (30) étant disposées entre au moins deux seconds évidements (7),
- la surface principale (14) présentant des structures (11) en forme de barrettes dans la séquence de couches semi-conductrices sur lesquelles sont disposées les première et seconde sections partielles(31, 32) des surfaces de contact électriques (30), et
- chacune des structures en forme de barrettes(11) présentant dans sa première section partielle (31) une première profondeur supérieure à une deuxième profondeur de la structure en forme de barrettes (11) dans la seconde section partielle (32).

2. Source de lumière laser selon la revendication 1, dans laquelle
- les secondes sections partielles (32) présentent chacune une forme trapézoïdale et jouxtent chacune la surface de couplage de rayonnement (12).

3. Source de lumière laser selon l'une des revendications précédentes, dans laquelle
- les premières sections partielles (31) s'étendent chacune en préservant une largeur constante sur la surface principale (14) le long de la direction d'émission (90).

4. Source de lumière laser selon l'une des revendications précédentes, dans laquelle
- la couche active (40) entre deux couches formant guide d'ondes (42, 43) est disposée sur un substrat (1), le premier évidement (6) s'étendant à partir de la surface principale (14) jusque dans au moins une couche choisie parmi la couche active (40), les couches formant guide d'ondes (42, 43) et le substrat (1).

5. Source de lumière laser selon l'une des revendications précédentes, dans laquelle
- le premier évidement (6) s'étend sur la surface principale (14) depuis la surface de découplage de rayonnement (12) jusqu'à une surface latérale (13) de la séquence de couches semi-conductrices (10) disposée en vis-à-vis de la surface de découplage de rayonnement (12).

6. Source de lumière laser selon l'une des revendications précédentes, dans laquelle
- le premier évidement (6) présente au moins une tranchée s'étendant parallèlement à la direction d'émission (90).

7. Source de lumière laser selon l'une des revendications précédentes, dans laquelle
- le premier évidement (6) présente des parois latérales délimitant un angle supérieur ou égal à 90° avec la surface principale (14).

8. Source de lumière laser selon l'une des revendications précédentes, dans laquelle
- dans le premier évidement (6) et/ou dans le second évidement (7), un matériau absorbant est disposé.

9. Source de lumière laser selon l'une des revendications précédentes, dans laquelle
- au moins un second évidement (7) présente une direction d'extension (92) qui délimite un angle supérieur à 0° et inférieur ou égal à 90° avec la direction d'émission (90).

10. Source de lumière laser selon l'une des revendications précédentes, dans laquelle
- au moins un second évidement (7) présente un écart par rapport à une surface de contact électrique (30) inférieur ou égal à 4 µm.

11. Source de lumière laser selon l'une des revendications précédentes, dans laquelle
- la couche active (40) entre deux couches formant guide d'ondes (42, 43) est disposée sur un substrat (1) et au moins un second évidement (7) s'étend à partir de la surface principale (14) jusque dans au moins une couche choisie parmi la couche active (40), les couches formant guide d'ondes (42, 43) et le substrat (1).

12. Source de lumière laser selon l'une des revendications précédentes, dans laquelle
- au moins un second évidement (7) présente des parois latérales délimitant un angle supérieur ou égal à 90° avec la surface principale (14).

13. Source de lumière laser selon l'une des revendications précédentes, dans laquelle la première profondeur entraîne un guidage d'indice, la seconde profondeur entraînant un guidage selon le principe du gain,
- la première profondeur s'étendant jusqu'à une couche formant guide d'ondes (43) de la séquence de couches semi-conductrices (10), la seconde profondeur s'étendant jusqu'à une couche de contact semi-conductrice (47) agencée au-dessus de la couche formant guide d'ondes (43) ou une couche de gaine (44) ou
- la première profondeur s'étend jusque dans une couche de gaine (44) et la seconde profondeur s'étend jusqu'à une interface entre la couche de gaine (44) et une couche de contact semi-conductrice (47) disposée ci-dessus ou seulement jusque dans la couche de contact semi-conductrice (47).

14. Source de lumière laser selon la revendication précédente, dans laquelle
- la surface principale (14) comprend une couche d'arrêt de gravure (46) jouxtant les structures en forme de barrettes (11).

15. Source de lumière laser selon l'une des revendications précédentes, dans laquelle
- la séquence de couches semi-conductrices (10) comprend de manière espacée vis-à-vis des au moins deux zones actives (45) au moins une zone active supplémentaire dans la couche active (40),
- la surface principale (14) comprend une surface de contact électrique (30') supplémentaire comportant des première et seconde sections partielles (31', 32') au-dessus la zone active supplémentaire,
- la structure surfacique comporte au moins un premier évidement supplémentaire (6') le long de la direction d'émission (90) qui est disposé entre les au moins deux surfaces de contact électrique (30) et la surface de contact électrique supplémentaire (30'), et
- la structure surfacique comprend deux seconds évidements (7') supplémentaires entre lesquels se voit agencée la première section partielle (31') de la surface de contact électrique supplémentaire (30').
